# EUROPEAN PATENT SPECIFICATION

(11) **EP 2 737 534 B1**
(45) Date of publication and mention of the grant of the patent: **08.01.2020**
(21) Application number: 12753701.7
(22) Date of filing: 24.08.2012
(51) Int. Cl.: F21K 9/00, F21K 9/90, H01L 25/075, H01L 33/00, H01L 27/15, H01L 33/60

(54) **LED LIGHT-EMITTING MODULE AND A METHOD FOR MANUFACTURING THE SAME**
LED LICHT-EMITTIERENDES MODUL UND VERFAHREN ZU SEINER HERSTELLUNG
MODULE ÉLECTROLUMINESCENT À DEL ET SON PROCÉDÉ DE FABRICATION

(30) Priority: 22.09.2011 CN 201110283505
(43) Date of publication of application: 04.06.2014
(73) Proprietor: OSRAM GmbH, 80807 München (DE)
(72) Inventor: CHEN, Peng, Shenzhen Guangdong 518053 (CN); LIU, Tingming, Shenzhen Guangdong 518053 (CN); MING, Yusheng, Shenzhen Guangdong 518053 (CN); ZHONG, Chuanpeng, Shenzhen Guangdong 518053 (CN)
(74) Representative: Schmidt, Steffen
(86) International application number: PCT/EP2012/066542
(87) International publication number: WO 2013/041325

(56) References cited:
- DE-A1-102007 032 274
- US-A1- 2005 073 840
- US-A1- 2007 075 325
- US-A1- 2010 079 059

## Description

### Technical Field

The present invention relates to an LED light-emitting module and a method for manufacturing the same.

### Background Art

With the development of the LED technology, various types of LED illuminating devices can replace conventional halogen lamps and are widely used in the street illumination. In the prior art, there is an LED illuminating device that can provide lw or 3w high power. In such illuminating device a plurality of individually encapsulated LED chips form a matrix module, and a thermal resistance of such illuminating device is quite high since there are too many thermal interfaces (such as from chips to a lead frame, from the lead frame to tin cream, from the tin cream to a printed circuit board, and from the printed circuit board to a heat sink). Moreover, as the light sources of such illuminating device are point light sources arranged symmetrically, only a circular light distribution can be provided, which is unfavorable for street illumination. In another prior embodiment, a reflector layer may be arranged on a printed circuit board provided with an LED light source. The advantage of such improved configuration is that the light distribution can be adjusted and changed by designing different reflectors, but the disadvantage is that the thermal resistance of the whole illuminating device is too big as the reflector layer is merely mechanically installed on the printed circuit board, which can hardly meet the thermal dissipation requirement of a high-power LED illuminating device.

In the document US 2007/0075325 A1 LED-chips arranged in a reflector are disclosed. Further embodiments of illuminating devices are shown in document US 2005/0073840 A1, DE 10 2007 032 274 A1 and US 2010/0079059 A1.

### Summary of the Invention

In order to overcome the above defects, the present invention provides an LED light-emitting module for an illuminating device and a method for manufacturing the same. The LED light-emitting module according to the present invention can produce a polarizing effect, and thus is particularly suited for street illumination; moreover, the LED light-emitting module also has the advantages of a simple structure, a low cost and a small thermal resistance.

One object of the present invention is accomplished via an LED light-emitting module. The LED light-emitting module comprising: a base board with at least one groove having a bottom; at least one printed circuit board (3) with an array of LED chips (4), be, respectively arranged in the groove, wherein respective LED chips are directly mounted on the printed circuit board through a COB process, and the LED light-emitting module further comprising a reflector on a side wall of the groove to reflect light from the LED chips, wherein the at least one printed circuit board is fixed in the at least one groove. Mounting high-power LED chips on the printed circuit board, especially on a metal-based circuit board, through the COB technology can advantageously avoid a thermal resistance caused by a lead frame and is thus favorable for thermal dissipation of the LED light-emitting module. Moreover, in this precondition, an asymmetric reflector arranged on the side wall of the groove can realize a polarized reflection to a predetermined direction. This disclosure comprises embodiments, some of which are embodiments of the invention as defined by the appended claims.

Accordingly, the LED light-emitting module according to the present invention exhibits the advantages of a simple and cheap manufacturing and a good polarizing effect.

According to a preferred solution of the present invention, the reflector and the base board are formed in one piece. Such configuration greatly saves the manufacturing cost and reduces the assembling steps, and can further avoid a possibility of offset from a predetermined reflection region caused by a manufacturing tolerance of the reflector. Particularly preferably, the reflector and the base board are formed in one piece through a hot die casting process.

According to a preferred solution of the present invention, the reflector is a reflective board extending unilaterally from the side wall of the groove. As a result, the so-called "asymmetric" reflector structure can be realized for producing a polarizing effect.

According to a preferred solution of the present invention, the reflector at least extends to a position where the respective LED chips are covered by the reflector. Herein, the reflector partially covers the LED chips from a side surface and a top surface, which enables part of light emitted from the LED chips to be reflected by the reflector, thus a desired polarizing effect can be produced and the luminescence efficiency is improved.

Further preferably, the reflector comprises a plurality of wing-shape reflective portions, and each LED chip is correspondingly allocated with one wing-shape reflective portion. The LED chip accordingly is located under an axis of symmetry of the wing-shape reflective portion; as a result, part of light emitted from the LED chips arrives at respective wing-shape reflective portions uniformly.

According to a preferred solution of the present invention, the wing-shape reflective potion comprises a first wing surface and a second wing surface arranged symmetrically and having a predetermined angle with a mounting plane. According to the optical principle and the geometric principle, the first and second wing surfaces are configured to be formed by a plurality of sections, respectively, so that an ideal reflective effect can be realized. Of course, the first and second wing surfaces also can be configured to be smooth curved surfaces according to practical requirements. In addition, the first and second wing surfaces have a predetermined angle, which thus is favorable for obtaining a desired light spot.

Preferably, the first wing surface and the second wing surface are reflective surfaces coated with a reflective material. Alternatively, the first wing surface and the second wing surface may undergo a surface oxidation process, which accordingly can further improve the luminescence efficiency and reduce the energy consumption.

According to another preferred solution of the present invention, the LED chips are directly fixed on the printed circuit board with a silver epoxy mixture. As the LED chips and the printed circuit board undergoing such typical COB process are integrated into a complete light-emitting module, and the thermal resistance associated with the lead frame is not introduced, the light-emitting module is enabled to have a minimum thermal resistance, which has a significant meaning in the illuminating device using a high-power LED chip.

According to a preferred solution of the present invention, the LED chips are encapsulated by filler and a gel wall surrounding the filler. Advantageously, the filler is silicone. Encapsulating the LED chips with the filler such as silicone can assure a long service lifetime of the LED chips in a wicked application condition and also meets the waterproof and dustproof requirements in industry. The silicone can improve, for instance, the anti-ultraviolet radiation performance and anti-oxidation performance of the LED chips in the street illumination. Of course, other materials having similar properties also may be used to encapsulate the LED chip.

Preferably, a heat sink is further provided between the reflector and the printed circuit board. As a result, a thermal dissipation area can be further increased, and the failure possibility caused by overheat of the assemblies can be reduced.

According to a preferred solution of the present invention, the base board is a long-strip shape and has a plurality of elongated and parallel grooves. Such special configuration is particularly advantageous for obtaining a long-strip light spot and quite favorable for application in, for example, the street illumination.

In addition, the present invention further relates to a method for manufacturing the LED light-emitting module above, including steps of:
a) providing a blank, and processing the blank into a base board provided with at least one groove, wherein a plurality of wing-shape portions are formed on a side wall of the groove;
b) processing a surface of the wing-shape reflective portion to form a first and a second reflective surface;
c) fixing a printed circuit board in the at least one groove and arranging a plurality of LED chips on the printed circuit board through a COB process; and
d) encapsulating the LED chips.

Preferably after step b), a mounting plane for mounting the printed circuit board is formed at a bottom of the groove through a milling process.

Preferably in step c), respective LED chips are arranged under an axis of symmetry of respective wing-shape reflective portions.

Preferably in step d), the LED chips are directly fixed on the printed circuit board with a silver epoxy mixture.

The LED light-emitting module manufactured thereby has the advantages of a simple structure, a low cost and a small thermal resistance, and also can produce a polarizing effect.

### Brief Description of the Drawings

The accompanying drawings constitute a part of the present Description and are used to provide further understanding of the present invention. Such accompanying drawings illustrate the embodiments of the present invention and are used to describe the principles of the present invention together with the Description. In the accompanying drawings the same components are represented by the same reference numbers. As shown in the drawings:
Fig. 1 is a 3D view of an LED light-emitting module according to the present invention;
Fig. 2 is a local 3D view of the LED light-emitting module in Fig. 1;
Fig. 3a is a top view of an LED light-emitting module according to the present invention;
Fig. 3b is an enlarged local view of Fig. 3a;
Fig. 3c is a lateral view of an LED light-emitting module according to the present invention; and
Fig. 4 is a light distribution diagram of an LED light-emitting module according to the present invention.

### Detailed Description of the Embodiments

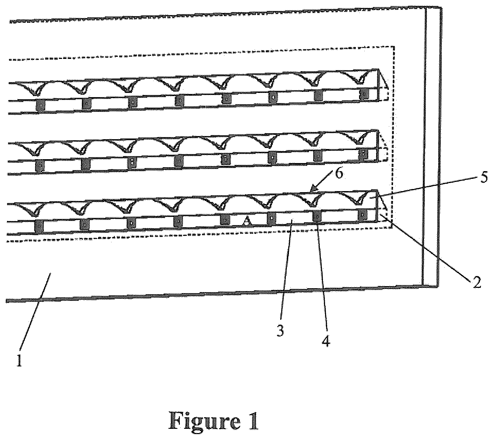

Fig. 1 is a 3D view of an LED light-emitting module according to the present invention, wherein the LED light-emitting module comprises a base board 1, a reflector 5, a printed circuit board 3 and LED chips 4. In the present preferred embodiment, a blank as the base board 1 undergoes a process such as hot die casting or punching to form the reflector 5 on the base board 1 in one piece in order to save the manufacturing cost and reduce the assembling steps. At least one groove 2 (three grooves in the present embodiment) are formed in the base board 1 after said processing, and the groove 2 has a flat bottom and side wall. The bottom, upon a milling process, can form a mounting plane A for mounting the printed circuit board 3, wherein the LED chip 4 is mounted on the printed circuit board 3 particularly through a COB process. The side wall of the groove 2 is used as the reflector 5; as a result, a light reflection offset caused by a manufacturing tolerance of the reflector 5 can be further avoided. Of course, the reflector 5 also may be additionally mounted on the side wall.

In order to realize a polarizing effect, the reflector 5 is a reflective board extending unilaterally from the side wall of the groove 2 to a direction covering the LED chips 4, thus forming an asymmetric configuration for reflecting light from the LED chips 4 to a predetermined direction. As can be seen from Fig. 1, the LED chips 4 are located at the bottom of the groove 2, and the reflector 5 extends to a position where the LED chips 4 are covered. Specifically, the reflector 5 covers part of side surface and top surface of the LED chips 4 to enable part of light emitted from the LED chips 4 to be reflected by the reflector 5, thus a desired polarizing effect can be produced. In order to further improve the luminescence efficiency, the reflector 5 comprises a plurality of wing-shape reflective portions 6, each of which comprises a first wing surface A1 and a second wing surface 2 arranged symmetrically. The wing-shape reflective portions 6 are corresponding to the LED chips 4 arranged under an axis of symmetry thereof one by one, consequently, part of light emitted from the LED chips 4 arrives at respective wing-shape reflective portions 6 uniformly.

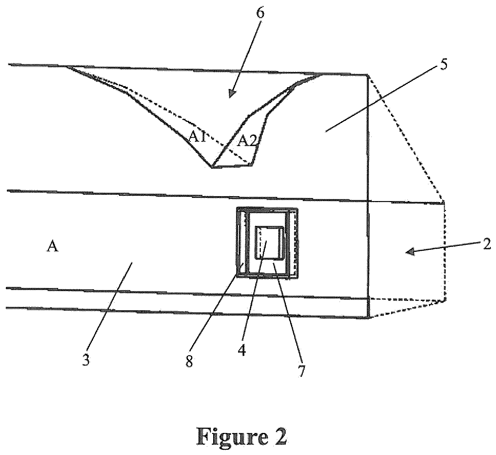

Fig. 2 is a local 3D view of the LED light-emitting module in Fig. 1, in which according to the COB process, the LED chips 4 are directly fixed on the printed circuit board 3 at the bottom of the groove 2 with a silver epoxy mixture to form a complete light-emitting module, without additional elements such as lead frame or thermal medium material in the prior art, as a result, a thermal resistance of the whole LED light-emitting module, especially a thermal resistance of a light-emitting module having a high-power LED chip, can be reduced. For the sake of a long service lifetime of the LED chips 4, the LED chips 4 are advantageously encapsulated in a gel wall with filler such as silicone to form a modularized structure. The silicone has a good anti-ultraviolet radiation performance and anti-oxidation performance, and therefore is particularly suited to encapsulate the LED chips 4 used outdoors. Of course, other materials having similar properties also may be used to encapsulate the LED chips 4.

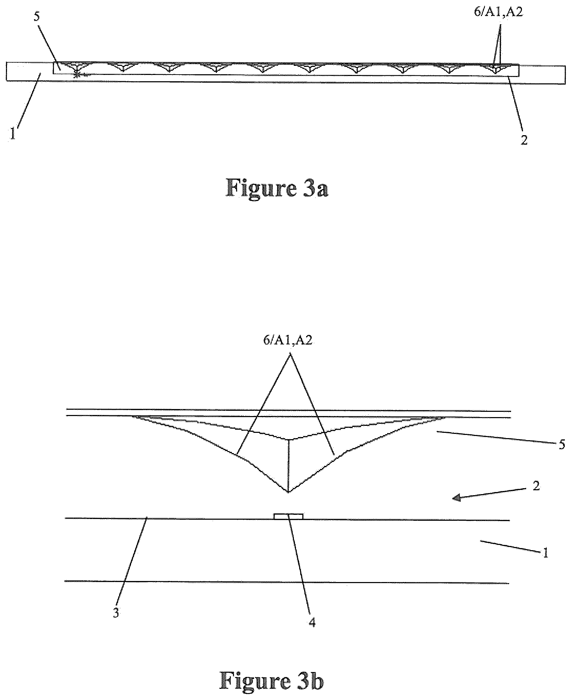

Fig. 3a is a top view of an LED light-emitting module according to the present invention. In conjunction with the enlarged local view shown in Fig. 3b, each wing-shape reflective portion 6 corresponds to one LED chip 4, and in the present embodiment, according to the optical principle and geometric principle, the first and second wing surfaces A1 and A2 are configured to be formed by a plurality of sections, respectively, and the first and second wing surfaces A1 and A2 have a predetermined angle therebetween, so that an ideal reflection effect can be realized. In order to further improve the luminescence efficiency, the first and second wing surfaces A1 and A2 and the side wall of the groove 2 may be coated with a reflective material, or undergo a surface oxidation process, or they are directly polished to become reflective surfaces.

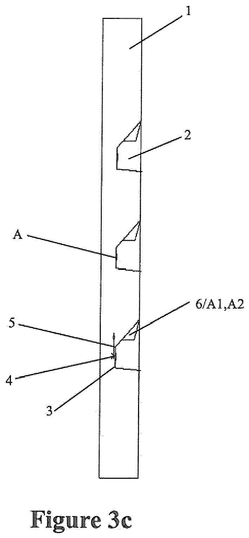

Fig. 3c is a lateral view of an LED light-emitting module according to the present invention. The LED chips 4 are located at the bottom of the trapeziform groove 2, i.e., at an upper bottom of the trapeziform shown in the lateral view. The wing-shape reflective portion 6 shown as a triangle covers above the LED chips 4. Light emitted from the LED chips 4 arrives at the reflector 5, i.e., the side wall of the groove 2 and the wing-shape reflective portion 6, in a direction parallel to bottoms of the trapeziform. Accordingly, the polarizing effect can be produced.

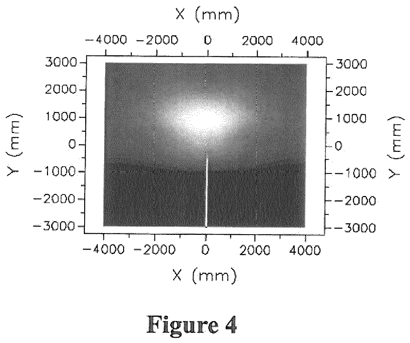

Fig. 4 is a light distribution diagram of an LED light-emitting module according to the present invention. It can be seen obviously from Fig. 4 a light spot offset on Y-axis with respect to an origin position. Such light distribution is particularly suited to the street illumination.

In a situation particularly for the street illumination, the LED light-emitting module according to the present invention has a long-strip base board 1 in which a plurality of elongated and parallel grooves 2 are provided, thus a uniform long-strip light spot can be obtained.

For the present invention, the printed circuit board 3 mentioned can be, preferably, a metal-based circuit board, and circuit boards of other types. In addition, a heat sink 9 (not shown) also may be provided between the reflector 5 and the printed circuit board 3 for further improving the thermal dissipation effect of the LED light-emitting module.

### List of reference signs

- 1: base board
- 2: groove
- 3: printed circuit board
- 4: LED chip
- 5: reflector
- 6: wing-shape reflective portion
- 7: filler
- 8: gel wall
- 9: heat sink
- A: mounting plane
- A1: first wing surface
- A2: second wing surface

## Claims

1. An LED light-emitting module comprising: a base board (1) with at least one groove (2) having a bottom; at least one printed circuit board (3) with an array of LED chips (4), respectively arranged in the groove (2), wherein respective LED chips (4) are directly mounted on the printed circuit board (3) through a COB process, and the LED light-emitting module further comprising a reflector (5) on a side wall of the groove (2) to reflect light from the LED chips (4), wherein the at least one printed circuit board is fixed in the at least one groove and the reflector (5) and the base board (1) are formed in one piece.

2. The LED light-emitting module according to Claim 1, wherein the reflector (5) and the base board (1) are formed in one piece through a hot die casting process.

3. The LED light-emitting module according to Claim 2, wherein the reflector (5) is a reflective board extending unilaterally from the side wall of the groove (2).

4. The LED light-emitting module according to Claim 3, wherein the reflector (5) at least extends to a position where the respective LED chips (4) are covered by the reflector (5).

5. The LED light-emitting module according to Claim 4, wherein the reflector (5) comprises a plurality of wing-shape reflective portions (6), and each LED chip (4) is correspondingly allocated with one wing-shape reflective portion (6).

6. The LED light-emitting module according to Claim 5, wherein the wing-shape reflective potion (6) comprises a first wing surface (A1) and a second wing surface (A2) arranged symmetrically and having a predetermined angle.

7. The LED light-emitting module according to Claim 6, wherein the first wing surface (A1) and the second wing surface (A2) are reflective surfaces coated with a reflective material.

8. The LED light-emitting module according to Claim 3, wherein the LED chips (4) are directly fixed on the printed circuit board (3) with a silver epoxy mixture.

9. The LED light-emitting module according to Claim 3, wherein the LED chips (4) are encapsulated by filler (7) and a gel wall (8) surrounding the filler (7).

10. The LED light-emitting module according to Claim 9, wherein the filler (7) is silicone.

11. The LED light-emitting module according to Claim 3, wherein a heat sink (9) is further provided between the reflector (5) and the printed circuit board (3).

12. The LED light-emitting module according to Claim 3, wherein the base board (1) is a long-strip shape and has a plurality of elongated and parallel grooves (2).

13. A method for manufacturing the LED light-emitting module according to any one of Claims 1-12, including steps of:
a) providing a blank, and processing the blank into a base board (1) with at least one groove (2), wherein a plurality of wing-shape portions (6) are formed on a side wall of the groove (2);
b) processing a surface of the wing-shape reflective portion (6) to form a first and a second reflective wing surfaces (A1, A2);
c) fixing a printed circuit board (3) in the at least one groove (2) and arranging a plurality of LED chips (4) on the printed circuit board (3) through a COB process; and
d) encapsulating the LED chips (4).

14. The method according to Claim 13, wherein after step b), a mounting plane (A) for mounting the printed circuit board (3) is formed at a bottom of the groove (2) through a milling process.

15. The method according to Claim 13, wherein in step c), respective LED chips (4) are arranged under an axis of symmetry of respective wing-shape reflective portions (6).

16. The method according to Claim 13, wherein in step d), the LED chips (4) are directly fixed on the printed circuit board (3) with a silver epoxy mixture.

## Patentansprüche

1. LED-Leuchtmodul, umfassend: eine Grundplatte (1) mit mindestens einer Nut (2) mit einem Boden; wenigstens eine Leiterplatte (3) mit einer Anordnung von LED-Chips (4), die jeweils in der Nut (2) angeordnet sind, wobei die jeweiligen LED-Chips (4) direkt auf der Leiterplatte (3) durch ein COB-Verfahren montiert sind, und das LED-Leuchtmodul ferner einen Reflektor (5) an einer Seitenwand der Nut (2) umfasst, um Licht von den LED-Chips (4) zu reflektieren, wobei die mindestens eine Leiterplatte in der mindestens einen Nut befestigt ist und der Reflektor (5) und die Grundplatte (1) in einem Stück ausgebildet sind.

2. LED-Leuchtmodul nach Anspruch 1, wobei der Reflektor (5) und die Grundplatte (1) durch ein Heißdruckgießverfahren einstückig ausgebildet sind.

3. LED-Leuchtmodul nach Anspruch 2, wobei der Reflektor (5) eine reflektierende Platte ist, die sich einseitig von der Seitenwand der Nut (2) erstreckt.

4. LED-Leuchtmodul nach Anspruch 3, wobei sich der Reflektor (5) zumindest bis zu einer Position erstreckt, in der die jeweiligen LED-Chips (4) durch den Reflektor (5) abgedeckt sind.

5. LED-Leuchtmodul nach Anspruch 4, wobei der Reflektor (5) eine Vielzahl von flügelförmigen reflektierenden Abschnitten (6) umfasst und jeder LED-Chip (4) entsprechend einem flügelförmigen reflektierenden Abschnitt (6) zugeordnet ist.

6. LED-Leuchtmodul nach Anspruch 5, wobei der flügelförmige reflektierende Abschnitt (6) eine erste Flügeloberfläche (A1) und eine zweite Flügeloberfläche (A2) umfasst, die symmetrisch angeordnet sind und einen vorbestimmten Winkel aufweisen.

7. LED-Leuchtmodul nach Anspruch 6, wobei die erste Flügelfläche (A1) und die zweite Flügelfläche (A2) reflektierende Oberflächen sind, die mit einem reflektierenden Material beschichtet sind.

8. LED-Leuchtmodul nach Anspruch 3, wobei die LED-Chips (4) direkt auf der Leiterplatte (3) mit einer Silber-Epoxid-Mischung befestigt sind.

9. LED-Leuchtmodul nach Anspruch 3, wobei die LED-Chips (4) mit Füllstoff (7) gekapselt sind und eine Gelwand (8) den Füllstoff (7) umgibt.

10. LED-Leuchtmodul nach Anspruch 9, wobei der Füllstoff (7) Silikon ist.

11. LED-Leuchtmodul nach Anspruch 3, wobei zwischen dem Reflektor (5) und der Leiterplatte (3) ferner ein Kühlkörper (9) vorgesehen ist.

12. LED-Leuchtmodul nach Anspruch 3, wobei die Grundplatte (1) eine längliche Streifenform aufweist und eine Vielzahl von länglichen und parallelen Nuten (2) aufweist.

13. Verfahren zur Herstellung des LED-Leuchtmoduls nach einem der Ansprüche 1-12, das Folgende Schritte aufweist:
a) Bereitstellen eines Rohlings und Bearbeiten des Rohlings zu einer Grundplatte (1) mit mindestens einer Nut (2), wobei eine Vielzahl von flügelförmigen Abschnitten (6) an einer Seitenwand der Nut (2) ausgebildet sind;
b) Bearbeiten einer Oberfläche des flügelförmigen reflektierenden Abschnitts (6), um eine erste und eine zweite reflektierende Flügeloberfläche (A1, A2) zu bilden;
c) Fixieren einer Leiterplatte (3) in der mindestens einen Nut (2) und Anordnen einer Vielzahl von LED-Chips (4) auf der Leiterplatte (3) durch ein COB-Verfahren; und
d) Verkapseln der LED-Chips (4).

14. Verfahren nach Anspruch 13, wobei nach Schritt b) durch einen Fräsvorgang an einem Boden der Nut (2) eine Montageebene (A) zur Montage der Leiterplatte (3) gebildet wird.

15. Verfahren nach Anspruch 13, wobei in Schritt c) jeweilige LED-Chips (4) unter einer Symmetrieachse der jeweiligen flügelförmigen reflektierenden Abschnitte (6) angeordnet sind.

16. Verfahren nach Anspruch 13, wobei in Schritt d) die LED-Chips (4) direkt auf der Leiterplatte (3) mit einer Silber-Epoxid-Mischung fixiert werden.

## Revendications

1. Module d'émission de lumière à DEL comprenant : une plaque de base (1) avec au moins une rainure (2) comportant un fond ; au moins une carte de circuit imprimé (3) avec un réseau de puces de DEL (4), respectivement agencées dans la rainure (2), dans lequel les puces de DEL (4) respectives sont montées directement sur la carte de circuit imprimé (3) par un processus COB, et le module d'émission de lumière à DEL comprend en outre un réflecteur (5) sur une paroi latérale de la rainure (2) pour réfléchir la lumière provenant des puces de DEL (4), dans lequel ladite au moins une carte de circuit imprimé est fixée dans ladite au moins une rainure et le réflecteur (5) et la plaque de base (1) sont formés en une seule pièce.

2. Module d'émission de lumière à DEL selon la revendication 1, dans lequel le réflecteur (5) et la plaque de base (1) sont formés en une seule pièce par un processus de coulée sous pression à chaud.

3. Module d'émission de lumière à DEL selon la revendication 2, dans lequel le réflecteur (5) est une carte réfléchissante s'étendant de manière unilatérale de la paroi latérale de la rainure (2).

4. Module d'émission de lumière à DEL selon la revendication 3, dans lequel le réflecteur (5) s'étend au moins jusqu'à une position où les puces de DEL (4) respectives sont recouvertes par le réflecteur (5).

5. Module d'émission de lumière à DEL selon la revendication 4, dans lequel le réflecteur (5) comprend une pluralité de parties réfléchissantes en forme d'aile (6), et une partie réfléchissante en forme d'aile (6) est attribuée de manière correspondante à chaque puce de DEL (4).

6. Module d'émission de lumière à DEL selon la revendication 5, dans lequel la partie réfléchissante en forme d'aile (6) comprend une première surface d'aile (A1) et une deuxième surface d'aile (A2) agencées symétriquement et formant un angle prédéterminé.

7. Module d'émission de lumière à DEL selon la revendication 6, dans lequel la première surface d'aile (A1) et la deuxième surface d'aile (A2) sont des surfaces réfléchissantes revêtues d'un matériau réfléchissant.

8. Module d'émission de lumière à DEL selon la revendication 3, dans lequel les puces de DEL (4) sont fixées directement sur la carte de circuit imprimé (3) avec un mélange argent-époxy.

9. Module d'émission de lumière à DEL selon la revendication 3, dans lequel les puces de DEL (4) sont encapsulées dans une charge (7) et une paroi de gel (8) entourant la charge (7).

10. Module d'émission de lumière à DEL selon la revendication 9, dans lequel la charge (7) consiste en du silicone.

11. Module d'émission de lumière à DEL selon la revendication 3, dans lequel un dissipateur de chaleur (9) est en outre prévu entre le réflecteur (5) et la carte de circuit imprimé (3).

12. Module d'émission de lumière à DEL selon la revendication 3, dans lequel la plaque de base (1) a la forme d'une longue bande et comporte une pluralité de rainures allongées et parallèles (2).

13. Procédé pour fabriquer le module d'émission de lumière à DEL selon l'une quelconque des revendications 1 à 12, comprenant les étapes :
a) de fourniture d'une ébauche, et de traitement de l'ébauche en une plaque de base (1) avec au moins une rainure (2), dans lequel une pluralité de parties en forme d'aile (6) sont formées sur une paroi latérale de la rainure (2) ;
b) de traitement d'une surface de la partie réfléchissante en forme d'aile (6) pour former des première et deuxième surfaces d'aile réfléchissantes (A1, A2) ;
c) de fixation d'une carte de circuit imprimé (3) dans ladite au moins une rainure (2) et d'agencement d'une pluralité de puces de DEL (4) sur la carte de circuit imprimé (3) par un processus COB ; et
d) d'encapsulation des puces de DEL (4).

14. Procédé selon la revendication 13, dans lequel, après l'étape b), un plan de montage (A) pour monter la carte de circuit imprimé (3) est formé au fond de la rainure (2) par un processus de fraisage.

15. Procédé selon la revendication 13, dans lequel, à l'étape c), des puces de DEL (4) respectives sont agencées sous un axe de symétrie des parties réfléchissantes en forme d'aile (6) respectives.

16. Procédé selon la revendication 13, dans lequel, à l'étape d), les puces de DEL (4) sont directement fixées sur la carte de circuit imprimé (3) par un mélange argent-époxy.
